(19) Europäisches Patentamt / European Patent Office / Office européen des brevets

(11) **EP 3 951 408 B1**

(12) **EUROPEAN PATENT SPECIFICATION**

(45) Date of publication and mention
of the grant of the patent:
**06.05.2026 Bulletin 2026/19**

(21) Application number: **20919394.5**

(22) Date of filing: **10.12.2020**

(51) International Patent Classification (IPC):
*G01R 31/392* (2019.01)    *G01R 31/367* (2019.01)
*G01R 31/388* (2019.01)    *G01R 31/382* (2019.01)

(52) Cooperative Patent Classification (CPC):
**G01R 31/392; G01R 31/367; G01R 31/382;
G01R 31/388**

(86) International application number:
**PCT/CN2020/135129**

(87) International publication number:
**WO 2021/258657 (30.12.2021 Gazette 2021/52)**

(54) **METHOD AND APPARATUS FOR ACQUIRING STATE OF HEALTH OF BATTERY, AND STORAGE MEDIUM**

VERFAHREN UND VORRICHTUNG ZUR ERFASSUNG DES GESUNDHEITSZUSTANDS EINER BATTERIE UND SPEICHERMEDIUM

PROCÉDÉ ET APPAREIL D'ACQUISITION DE L'ÉTAT D'UNE BATTERIE, ET SUPPORT D'ENREGISTREMENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.06.2020 CN 202010588936**

(43) Date of publication of application:
**09.02.2022 Bulletin 2022/06**

(73) Proprietors:
• **Guangzhou Chengxing Zhidong Motors
Technology Co., Ltd.
Guangzhou, Guangdong 510700 (CN)**
• **Guangzhou Xiaopeng Motors Technology Co.,
Ltd.
Guangzhou, Guangdong 510630 (CN)**

(72) Inventors:
• **YOU, Shiyun
Guangdong 510700 (CN)**
• **LIU, Haiyang
Guangdong 510700 (CN)**
• **MAO, Jun
Guangdong 510700 (CN)**

(74) Representative: **Isarpatent
Patent- und Rechtsanwälte Barth
Charles Hassa Peckmann & Partner mbB
Friedrichstrasse 31
80801 München (DE)**

(56) References cited:
CN-A- 103 675 704    CN-A- 108 061 863
CN-A- 108 061 863    CN-A- 110 568 375
CN-A- 111 123 138    CN-A- 111 736 083
US-A1- 2004 257 045    US-A1- 2015 120 225
US-A1- 2015 276 887    US-A1- 2015 346 285

**Description**

TECHNICAL FIELD

The present disclosure relates to the technical field of batteries, and particularly relates to a method and device for acquiring a state of health of a battery, a vehicle, a computer program product and a computer-readable storage medium.

BACKGROUND

For new energy vehicles, especially pure electric vehicles, lithium-ion power batteries are the main power sources. A state of health (SOH) of the battery is an important parameter of the power battery, which indicates an aging degree of the battery, that is, the attenuation of a capacity and the increase of an internal resistance. The SOH is also related to the estimation of other important states of the battery, such as a state of charge(SOC) and an allowable power, which directly affect a driving range and a driving experience. Therefore, how to accurately estimate the SOH of the battery is an important issue for the pure electric vehicles.

Currently, the SOH of the lithium-ion power battery for the new energy vehicle is generally estimated by: firstly measuring a cycle number of the battery, and then obtaining the state of health SOH of the battery by querying a correspondence table between the cycle number measured in advance and the SOH. In fact, due to the different temperatures and working conditions of the battery in different vehicles and differences between the batteries, the SOHs of different batteries are actually different even with the same cycle times, so this method cannot truly reflect the actual SOH of the battery, which leads to inaccurate estimation of the SOC and the driving range, and seriously affects the driving experience of users.

US 2015/0346285 A1 discloses a device for assessing an extent of degradation of a secondary battery, including: a determination unit that determines whether or not a value of current flowing in the secondary battery is less than a predetermined value; a first voltage measurement unit that takes a time point at which it is determined by the determination unit that the value of the current is less than the predetermined value as being a start time point of a specific interval, and that measures a first battery voltage of the secondary battery at the start time point; a first charge amount calculation unit that obtains a first charge amount corresponding to the secondary battery based upon the measured first battery voltage; a second voltage measurement unit that, after the first battery voltage has been measured by the first voltage measurement unit, takes a time point at which it is determined by the determination unit that the value of the current is less than the predetermined value as being an end time point of the specific interval, and that measures a second battery voltage of the secondary battery at the end time point; a second charge amount calculation unit that obtains a second charge amount corresponding to the secondary battery based upon the measured second battery voltage; an integrated current amount calculation unit that obtains an integrated amount of the current flowing in the secondary battery during the specific interval; and a charge capacity calculation unit that obtains a difference between the first charge amount and the second charge amount, and that calculates a charge capacity by dividing the integrated amount of the current by the difference.

US 2015/0120225 A1 discloses an apparatus and a method for determining degradation of a high-voltage vehicle battery. The apparatus for determining degradation of a high-voltage vehicle battery is configured to measure a battery state of health (SOH) according to a preset estimation calculation, thereby minimizing a battery degradation estimation error. It is possible to calculate a capacity of a battery only using a current value and a state of charge (SOC) change value to estimate an SOH of the battery, thereby simplifying an algorithm for the estimation. In particular, it is also advantageously possible to estimate a battery SOH through a first estimation algorithm, compare the estimated battery SOH with a threshold value, determine whether to perform re-estimation and if the re-estimation is determined, re-estimate the battery SOH through a second estimation algorithm, using a least mean square method, thereby minimizing an error in a battery SOH estimation value.

US 2004/0257045 A1 discloses a voltage control apparatus which checks a battery voltage when an automotive generator gradually increases its output to be within a predetermined range after temporarily stopping the generator. Then, the battery voltage is picked up to calculate the charge rate. Further, a first charge rate and a first residual capacity of the battery are memorized when the engine is stopped. Periodically, a pseudo-open circuit voltage is checked when a charge/discharge current fits within a pre-determined small range while the engine is not running, and a second charge rate is calculated based on the checked pseudo-open circuit voltage. A second residual capacity is calculated using the first charge rate, the first residual capacity, and the second charge rate.

CN 108061863 A discloses a battery detection method and a device, a computer readable storage medium and a battery management system which relate to the field of battery technology. The short board cell is first determined, and then the SOH of at least one short board cell is obtained. The SOH that meets the measurement conditions can accurately reflect the SOH of the battery. The calculation process is simple, the calculation amount is small, the time is short, the system load is reduced, and the system running speed is improved. The method includes determining at least one short board cell in the battery according to the charge and discharge of each cell in the battery; calculating the SOH of the health state of at least one short board cell; and determining the SOH of the battery according to the SOH of at least one short board cell that meets the measurement conditions. The technical scheme provided is suitable for determining the SOH of the battery.

## SUMMARY

The embodiments of the present disclosure disclose a method and device for acquiring a state of health of a battery, a vehicle, a computer program product and a computer-readable storage medium, which can improve a calculation accuracy of the state of health of the battery.

The invention is set out in the appended claims.

Compared with the prior art, the embodiments of the present disclosure have the following advantageous effects: it is not necessary to measure a corresponding relation between a cycle number during a life cycle of the battery and the SOH, thus saving test resources and time; an aging degree of the actual capacity of the battery is more truly reflected, an estimation accuracy of a state of charge and a driving range is improved, and a good driving experience is provided for users.

## BRIEF DESCRIPTION OF THE DRAWINGS

In order to illustrate the technical solutions in the embodiments of the present disclosure more clearly, the drawings used in the embodiments will be briefly described below. Obviously, the drawings in the following description relate to the embodiments defined in the claims and present also further examples, aspects, implementations, non-claimed embodiments, etc. for the better understanding of the invention as defined by the embodiments of the appended claims. For those of ordinary skills in the art, other drawings may also be obtained based on these drawings without any creative work.

FIG. 1 is a flow chart of an embodiment of a method for acquiring a state of health of a battery disclosed in an embodiment of the present disclosure;

FIG. 2 is a flow chart of another embodiment of a method for acquiring a state of health of a battery disclosed in an embodiment of the present disclosure; and

FIG. 3 is a schematic diagram of modules of an embodiment of a device for acquiring a state of health of a battery disclosed in an embodiment of the present disclosure.

## DETAILED DESCRIPTION

The following clearly and completely describes the technical solutions in the embodiments of the present disclosure with reference to the accompanying drawings in the embodiments of the disclosure. Apparently, the described embodiments are merely some but not all of the embodiments of the present disclosure. In this respect, the invention is defined by the embodiments disclosed by the appended claims.

It should be noted that the terms "first", "second", "third" and "fourth" and the like in the specification and claims of the present disclosure as well as the above drawings are used to distinguish different objects, and are not used to describe a specific sequence. The terms "comprise" and "have" and any deformation thereof are intended to cover a non-exclusive inclusion, for example, a process, method, system, product, or device that comprises a series of steps or units is not necessarily limited to those steps or units that are explicitly listed, but may comprise other steps or units that are not explicitly listed or inherent to such process, method, product or device.

The embodiments of the present disclosure provide a method for acquiring a state of health of a battery, which mainly, according to an OCV-SOC (Open Circuit Voltage-State of Charge) curve of the battery, finds two SOC points corresponding to the OCV-SOC curve according to an OCV (Open Circuit Voltage) during the use of a vehicle, and accumulates a capacity variation between the two points, and divides the capacity variation by an SOC difference between the two points, to obtain a current actual capacity of the battery. A ratio of the current actual capacity of the battery to a nominal capacity of the battery delivered from a factory is converted into a percentage, which is an SOH. The method is illustrated hereinafter with reference to the specific embodiments.

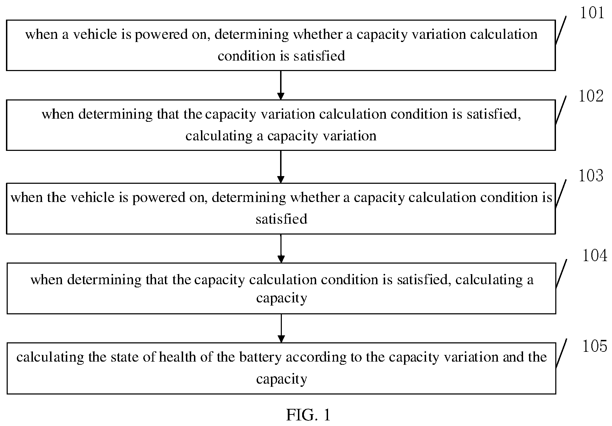

FIG. 1 is a flow chart of an embodiment of a method for acquiring a state of health of a battery according to the embodiments of the present disclosure, comprising:

101: when a vehicle is powered on, determining whether a capacity variation calculation condition is satisfied; the capacity variation calculation condition comprises two conditions A and B as below:

capacity variation calculation condition A: a parking time is greater than or equal to S1;

the parking time being a time interval between last power-off and the present power-on;

S1 being a preset parking time threshold of the capacity variation calculation condition, and preferably, S1 being a time required for the battery at a static state to remove a polarization terminal voltage and achieve stability;

capacity variation calculation condition B: SOC1 is less than or equal to SOC_judge1, wherein SOC1 is an SOC value of the battery corresponding to a current voltage of the battery with a minimum unit voltage in an OCV-SOC curve;

the battery corresponding to the minimum unit voltage is namely the one with the minimum unit voltage in all the unit batteries in the current battery; the SOC value corresponding to the current voltage can be acquired through the OCV-SOC curve of the battery, and this value is recorded as SOC1; and

the SOC_judge1 is a preset SOC threshold of the capacity variation calculation condition, and preferably, the SOC_judge1 may be set as a lowest SOC point of a platform area of the OCV-SOC curve, and the platform area of the OCV-SOC curve refers to an area where a slope of the OCV-SOC curve is less than a certain value, such as less than 8 mV per 1% SOC;

when the above two conditions are satisfied, it is deemed that the capacity variation calculation condition is satisfied;

102: when determining that the capacity variation calculation condition is satisfied, calculating a capacity variation;

the two parameters as follows are respectively calculated:

$$\Delta\mathrm{Cap} = \int_{\mathrm{T1}}^{\mathrm{RTC}} - I dt$$

$$\Delta\mathrm{DchaCap} = \int_{\mathrm{T1}}^{\mathrm{RTC}} I_{\mathrm{d}} dt$$

wherein,

T1 is a time point when determining that the capacity variation calculation condition is satisfied;

RTC is a time to calculate $\Delta$Cap or $\Delta$DchaCap, which may be acquired by internal timing of a BMS or acquired externally;

$I$ is a current of the battery;

$I_{\mathrm{d}}$ is a current in a discharge direction of the battery;

$\Delta$Cap is a capacity variation accumulated from a start time of T1; and

$\Delta$DchaCap is the capacity variation in the discharge direction accumulated from the start time of T1; and

103: when the vehicle is powered on, determining whether a capacity calculation condition is satisfied;

the capacity calculation condition comprises four conditions A, B, C and D as below:

capacity calculation condition A: a parking time is greater than or equal to S2;

the parking time being a time interval between last power-off and the present power-on;

S2 being a preset time threshold of the capacity calculation condition, and preferably, S2 being a time required for the battery at a static state to remove a polarization terminal voltage and achieve stability;

capacity variation calculation condition B: SOC2 is less than or equal to SOC_judge2, wherein SOC2 is an SOC value of a voltage value of the battery corresponding to a maximum unit voltage in an OCV-SOC curve;

the battery corresponding to the maximum unit voltage is namely the one with the maximum unit voltage in all the unit batteries in the current battery; the SOC value corresponding to the current voltage can be acquired through the OCV-SOC curve of the battery, and this value is recorded as SOC2; and

the SOC_judge2 is a preset SOC threshold of the capacity calculation condition, and preferably, the SOC_judge2 may be set as a highest SOC point of a platform area of the OCV-SOC curve, and the platform area of the OCV-SOC curve refers to an area where a slope of the OCV-SOC curve is less than a certain value, such as less than 8 mV per 1% SOC;

capacity calculation condition C: CT-T1 is less than or equal to T_Judge;

wherein:

CT is a time point when determining whether the capacity calculation condition is satisfied;

T1 is a time point when determining that the capacity variation calculation condition is satisfied;

T_Judge is a preset time difference threshold, which represents a maximum allowable value of a time difference between SOC1 and SOC2; this value is usually not too large, because if this value is too large, the capacity variation of long-term self-discharge of the battery will not be accumulated in $\Delta$Cap, which will reduce an accuracy of a final result; and in some embodiments, this threshold may be set to 5 days, for example; and

capacity calculation condition D: $\Delta$DchaCap$\leq\Delta$DchaCap_Judge;

wherein:

$\Delta$DchaCap is the capacity variation in the discharge direction accumulated from the start time of T1; and

$\Delta$DchaCap_Judge is a preset capacity variation threshold, which represents a maximum allowable discharge amount between SOC1 and SOC2, and prevents an accuracy of a result from being lowered due to inaccurate $\Delta$Cap due to an excessive current sampling error under large discharge conditions; and in some embodiments, this threshold may be set to 0.5*Cap_rate, wherein Cap_rate is a nominal capacity;

when the above four conditions are satisfied, it is deemed that the capacity calculation condition is satisfied;

104: when determining that the capacity calculation condition is satisfied, calculating a capacity; specifically comprising:

$$\text{Cap\_cal} = \frac{\Delta Cap}{SOC2 - SOC1}$$

wherein,

Cap_cal is an actual capacity of the battery; and

$\Delta$Cap is a capacity variation accumulated from a start time of T1; and

105: calculating the SOH according to the capacity variation and the capacity:

$$\text{SOH\_C} = \frac{Cap\_cal}{Cap\_rate} \times 100\%$$

wherein,

SOH_C is the state of health (SOH) of the battery; and

Cap_rate is a nominal capacity of the battery delivered from a factory.

It can be seen from the above description that the embodiments of the present disclosure at least have the advantageous effects as follows.

Better selection methods of SOC1 and SOC2 are adopted, such that the capacity variation $\Delta$Cap as well as the capacity variation $\Delta$DchaCap in the discharge direction are accumulated accurately. Therefore, the calculation accuracy of the current actual capacity of the battery and the state of health (SOH) of the battery reflecting the capacity is high.

It is not necessary to measure a corresponding relation between a cycle number during a life cycle of the battery and the SOH, thus saving test resources and time.

An aging degree of the actual capacity of the battery is more truly reflected, an estimation accuracy of a state of charge and a driving range is improved, and a good driving experience is provided for users.

The above describes one method embodiment for estimating SOH in a logical forward way. In fact, since estimating SOH is usually not completed during one power-on and power-off process, in actual implementation, the embodiment implemented in a time forward way does not seem to be completely the same as the above solution. The following describes the embodiment implemented in the time forward way.

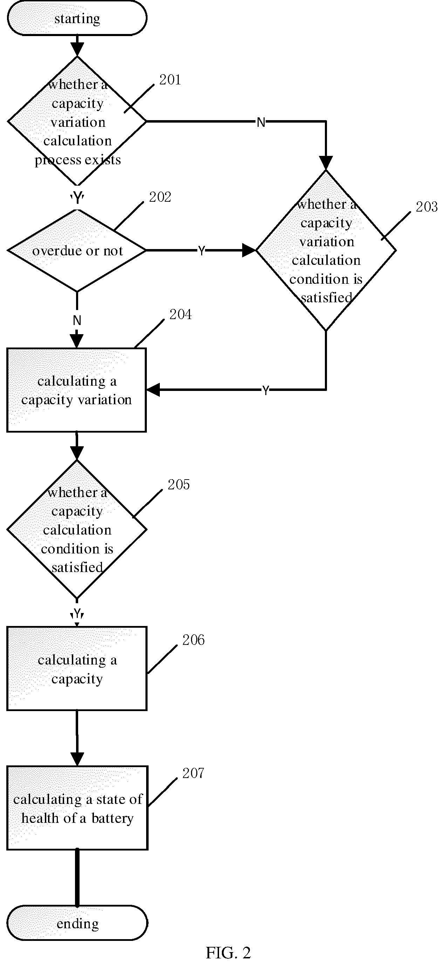

FIG. 2 is a flow chart of another embodiment of a method for acquiring a state of health of a battery according to the embodiments of the present disclosure, comprising:

201: when the vehicle is powered on, determining whether an ongoing capacity variation calculation process exists at present;

if the capacity variation calculation process exists, there will be a corresponding record in a battery management system usually, and whether the capacity variation calculation process exists can be known through the record;

if the ongoing capacity variation calculation process exists, determining whether the ongoing capacity variation calculation process is overdue;

since each capacity variation calculation process has a time limit, it will be determined whether the capacity variation calculation condition is satisfied again after the time limit is exceeded;

if no ongoing capacity variation calculation process exists, determining whether the capacity variation calculation condition is satisfied;

202: determining whether the capacity variation calculation process is overdue;

the capacity variation calculation process usually has a certain time limit, for example, in some embodiments of the present disclosure, the time limit may be limited to no more than 5 days from the time point when the capacity variation calculation condition is satisfied;

if the capacity variation calculation process is not overdue, calculating a capacity variation;

if the capacity variation calculation process is overdue, determining whether the capacity variation calculation condition is satisfied;

203: determining whether the capacity variation calculation condition is satisfied;

the capacity variation calculation condition comprising conditions A and B as below:

capacity variation calculation condition A: a parking time is greater than or equal to S1;

the parking time being a time interval between last power-off and the present power-on;

S1 being a preset parking time threshold of the capacity variation calculation condition, and preferably, S1 being a time required for the battery at a static state to remove a polarization terminal voltage and achieve stability;

capacity variation calculation condition B: SOC1 is less than or equal to SOC_judge1, wherein SOC1 is an SOC value of the battery corresponding to a current voltage of the battery with a minimum unit voltage in an OCV-SOC curve;

the battery corresponding to the minimum unit voltage is namely the one with the minimum unit voltage in all the unit batteries in the current battery; the SOC value corresponding to the current voltage can be acquired through the OCV-SOC curve of the battery, and this value is recorded as SOC1; and

the SOC_judge1 is a preset SOC threshold of the capacity variation calculation condition, and preferably, the SOC_judge1 may be set as a lowest SOC point of a platform area of the OCV-SOC curve, and the platform area of the OCV-SOC curve refers to an area where a slope of the OCV-SOC curve is less than a certain value, such as less than 8 mV per 1% SOC;

when the above two conditions are satisfied, it is deemed that the capacity variation calculation condition is satisfied;

204: calculating a capacity variation;

the two parameters as follows are respectively calculated:

$$\Delta\mathrm{Cap} = \int_{\mathrm{T1}}^{\mathrm{RTC}} - I dt$$

$$\Delta\mathrm{DchaCap} = \int_{\mathrm{T1}}^{\mathrm{RTC}} I_{\mathrm{d}} dt$$

wherein,

T1 is a time point when determining that the capacity variation calculation condition is satisfied;

RTC is a time to calculate ΔCap or ΔDchaCap, which may be acquired by internal timing of a BMS or acquired externally;

$I$ is a current of the battery;

$I_{\mathrm{d}}$ is a current in a discharge direction of the battery;

Cap is a capacity variation accumulated from a start time of T1; and

ΔDchaCap is the capacity variation in the discharge direction accumulated from the start time of T1; and

205: determining whether a capacity calculation condition is satisfied;

the capacity calculation condition comprises four conditions A, B, C and D as below:

capacity calculation condition A: a parking time is greater than or equal to S2;

the parking time being a time interval between last power-off and the present power-on;

S2 being a preset time threshold of the capacity calculation condition, and preferably, S2 being a time required for the battery at a static state to remove a polarization terminal voltage and achieve stability;

capacity variation calculation condition B: SOC2 is less than or equal to SOC_judge2, wherein SOC2 is an SOC value of a voltage value of the battery corresponding to a maximum unit voltage in an OCV-SOC curve; the battery corresponding to the maximum unit voltage is namely the one with the maximum unit voltage in all the unit batteries in the current battery; the SOC value corresponding to the current voltage can be acquired through the OCV-SOC curve of the battery, and this value is recorded as SOC2; and

the SOC_judge2 is a preset SOC threshold of the capacity calculation condition, and preferably, the SOC_judge2 may be set as a highest SOC point of a platform area of the OCV-SOC curve, and the platform area of the OCV-SOC curve refers to an area where a slope of the OCV-SOC curve is less than a certain value, such as less than 8 mV per 1% SOC;

capacity calculation condition C: CT-T1 is less than or equal to T_Judge;

wherein:

CT is a time point when determining whether the capacity calculation condition is satisfied;

T1 is a time point when determining that the capacity variation calculation condition is satisfied;

T_Judge is a preset time difference threshold, which represents a maximum allowable value of a time difference between SOC1 and SOC2; this value is usually not too large, because if this value is too large, the capacity variation of long-term self-discharge of the battery will not be accumulated in $\Delta$Cap, which will reduce an accuracy of a final result; and in some embodiments, this threshold may be set to 5 days, for example;

capacity calculation condition D: $\Delta$DchaCap is less than or equal to $\Delta$DchaCap_Judge;

wherein:

$\Delta$DchaCap is the capacity variation in the discharge direction accumulated from the start time of T1; and

$\Delta$DchaCap_Judge is a preset capacity variation threshold, which represents a maximum allowable discharge amount between SOC1 and SOC2, and prevents an accuracy of a result from being lowered due to inaccurate $\Delta$cap due to an excessive current sampling error under large discharge conditions; and in some embodiments, this threshold may be set to 0.5*Cap_rate, for example, wherein Cap_rate is a nominal capacity;

when the above four conditions are satisfied, it is deemed that the capacity calculation condition is satisfied;

206: calculating a current actual capacity of the battery;

specifically:

$$Cap\_cal = \frac{\Delta Cap}{SOC2 - SOC1}$$

wherein, $\Delta$Cap is a capacity variation accumulated from a start time of T1;

SOC2 is the SOC value of the voltage value of the battery corresponding to the minimum unit voltage in the OCV-SOC curve acquired when determining whether the capacity calculation condition is satisfied; and

SOC1 is the SOC value of the battery corresponding to the current voltage of the battery with the minimum unit voltage in the OCV-SOC curve when determining whether the capacity variation calculation condition is satisfied; and

207: calculating the SOH according to the capacity and the capacity variation;

$$SOH\_C = \frac{Cap\_cal}{Cap\_rate} \times 100\%$$

wherein,

SOH_C is the state of health (SOH) of the battery; and

Cap_rate is a nominal capacity of the battery delivered from a factory.

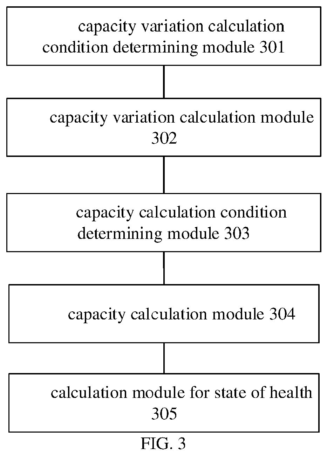

The embodiments of the present disclosure also provide a device for acquiring a state of health of a battery. FIG. 3 is a schematic diagram of modules of the device for acquiring the state of health of the battery disclosed by the present disclosure, comprising:

a capacity variation calculation condition determining module 301 configured for, when a vehicle is powered on, determining whether a capacity variation calculation condition is satisfied;

the capacity variation calculation condition comprises two conditions A and B as below:

capacity variation calculation condition A: a parking time is greater than or equal to S1;

the parking time being a time interval between last power-off and the present power-on;

S1 being a preset parking time threshold of the capacity variation calculation condition, and preferably, S1 being a time required for the battery at a static state to remove a polarization terminal voltage and achieve stability;

capacity variation calculation condition B: SOC1 is less than or equal to SOC_judge1, wherein SOC1 is an SOC value of the battery corresponding to a current voltage of the battery with a minimum unit voltage in an OCV-SOC curve;

the battery corresponding to the minimum unit voltage is namely the one with the minimum unit voltage in all the unit batteries in the current battery; the SOC value corresponding to the current voltage can be acquired through the OCV-SOC curve of the battery, and this value is recorded as SOC1; and

the SOC_judge1 is a preset SOC threshold of the capacity variation calculation condition, and preferably, the SOC_judge1 may be set as a lowest SOC point of a platform area of the OCV-SOC curve, and the platform area of the OCV-SOC curve refers to an area where a slope of the OCV-SOC curve is less than a certain value, such as less than 8 mV per 1% SOC;

when the above two conditions are satisfied, it is deemed that the capacity variation calculation condition is satisfied;

a capacity variation calculation module 302 configured for calculating a capacity variation;

the two parameters as follows are specifically and respectively calculated:

$$\Delta\mathrm{cap} = \int_{T1}^{RTC} - I dt$$

$$\Delta\mathrm{dchaCap} = \int_{T1}^{RTC} I_d dt$$

wherein,

T1 is a time point when determining that the capacity variation calculation condition is satisfied;

RTC is a time to calculate ∆cap or ∆dchaCap, which may be acquired by internal timing of a BMS or acquired externally;

$I$ is a current of the battery;

$I_d$ is a current in a discharge direction of the battery;

∆Cap is a capacity variation accumulated from a start time of T1; and

∆DchaCap is the capacity variation in the discharge direction accumulated from the start time of T1;

a capacity calculation condition determining module 303 configured for, when the vehicle is powered on, determining whether a capacity calculation condition is satisfied;

the capacity calculation condition comprises four conditions A, B, C and D as below:

capacity calculation condition A: a parking time is greater than or equal to S2;

the parking time being a time interval between last power-off and the present power-on;

S2 being a preset time threshold of the capacity calculation condition, and preferably, S2 being a time required for the battery at a static state to remove a polarization terminal voltage and achieve stability;

capacity variation calculation condition B: SOC2 is less than or equal to SOC_judge2, wherein SOC2 is an SOC value of a voltage value of the battery corresponding to a maximum unit voltage in an OCV-SOC curve;

the battery corresponding to the maximum unit voltage is namely the one with the maximum unit voltage in all the unit batteries in the current battery; the SOC value corresponding to the current voltage can be acquired through the OCV-SOC curve of the battery, and this value is recorded as SOC2; and

the SOC_judge2 is a preset SOC threshold of the capacity calculation condition, and preferably, the SOC_judge2 may be set as a highest SOC point of a platform area of the OCV-SOC curve, and the platform area of the OCV-SOC curve refers to an area where a slope of the OCV-SOC curve is less than a certain value, such as less than 8 mV per 1% SOC;
capacity calculation condition C: CT-T1 is less than or equal to T_Judge;
wherein:

CT is a time point when determining whether the capacity calculation condition is satisfied;
T1 is a time point when determining that the capacity variation calculation condition is satisfied; and
T_Judge is a preset time difference threshold, which represents a maximum allowable value of a time difference between SOC1 and SOC2; this value is usually not too large, because if this value is too large, the capacity variation of long-term self-discharge of the battery will not be accumulated in ΔCap, which will reduce an accuracy of a final result; and in some embodiments, this threshold may be set to 5 days, for example;
capacity calculation condition D: ΔDchaCap≤ΔDchaCap_Judge;
wherein:

ΔDchaCap is the capacity variation in the discharge direction accumulated from the start time of T1; and
ΔDchaCap_Judge is a preset capacity variation threshold, which represents a maximum allowable discharge amount between SOC1 and SOC2, and prevents an accuracy of a result from being lowered due to inaccurate ΔCap due to an excessive current sampling error under large discharge conditions; and in some embodiments, this threshold may be set to 0.5*Cap_rate, for example, wherein Cap_rate is a nominal capacity;
when the above four conditions are satisfied, it is deemed that the capacity calculation condition is satisfied;
a capacity calculation module 304 configured for calculating a capacity; and
specifically configured for calculating:

$$\mathrm{Cap\_cal} = \frac{\Delta Cap}{SOC2 - SOC1}$$

wherein,
Cap_cal is an actual capacity of the battery; and
ΔCap is a capacity variation accumulated from a start time of T1; and
a calculation module for state of health 305 configured for calculating the state of health (SOH) of the battery according to the capacity variation and the capacity;

$$\mathrm{SOH\_C} = \frac{Cap\_cal}{Cap\_rate} \times 100\%$$

wherein,
SOH_C is the state of health (SOH) of the battery; and
Cap_rate is a nominal capacity of the battery delivered from a factory.

It can be seen from the above description that the embodiments of the present disclosure at least have the advantageous effects as follows.

Better selection methods of SOC1 and SOC2 are adopted, such that the capacity variation ΔCap and the capacity variation ΔDchaCap in the discharge direction are accumulated accurately. Therefore, the calculation accuracy of the current actual capacity of the battery and the state of health (SOH) of the battery reflecting the capacity is high;

It is not necessary to measure a corresponding relation between a cycle number during a life cycle of the battery and the SOH, thus saving test resources and time.

An aging degree of the actual capacity of the battery is more truly reflected, an estimation accuracy of a state of charge and a driving range is improved, and a good driving experience is provided for users.

The embodiments of the present disclosure also disclose a vehicle, and the vehicle comprises the device for acquiring the state of health of the battery.

The embodiments of the present disclosure also disclose a computer-readable storage medium storing a computer program, wherein the computer program causes a computer to execute any of the method for acquiring the state of health of the battery above.

The embodiments of the present disclosure also disclose a computer program product, wherein the computer program product, when running on a computer, causes the computer to execute part or all of the steps of the method as in the above method embodiments.

Aspects of the present disclosure also disclose an application publishing platform, and the application publishing platform is configured for publishing a computer program product, wherein when the computer program product runs on a computer, the computer is caused to execute part or all of the steps of the method as in the above method embodiments.

Those of ordinary skills in the art can understand that all or part of the steps in the various methods of the above embodiments can be completed by instructing related hardware through programs, and the program can be stored in a computer-readable storage medium. The storage medium comprises a Read-Only Memory (ROM), a Random Access Memory (RAM), a Programmable Read-only Memory (PROM), an Erasable Programmable Read Only Memory (EPROM), a One-time Programmable Read-Only Memory (OTPROM), an Electrically-Erasable Read-Only Memory (EEPROM), a Compact Disc Read-Only Memory (CD-ROM), or other optical disc memory, magnetic disc memory, magnetic tape memory, or any other computer-readable medium that can be used to carry or store data.

The method and device for acquiring the state of health of the battery, and the storage medium disclosed by the embodiments of the present disclosure are described in detail above. Specific examples are applied to explain the principle and implementation of the present disclosure herein. The explanations of the above embodiments are only used to help understand the method of the present disclosure and the core idea thereof. Meanwhile, for those of ordinary skills in the art, there will be changes in the specific implementation and application scope according to the idea of the present disclosure. To sum up, the contents of this specification should not be construed as limiting the present disclosure. In this regard, the invention is defined by the claims.

**Claims**

1. A method for acquiring a state of health of a battery, wherein the method is carried out by the device according to claim 4, and wherein the method comprises:

   when a vehicle is powered on, determining (101) whether a capacity variation calculation condition is satisfied;
   when determining that the capacity variation calculation condition is satisfied, calculating (102) a capacity variation;
   when the vehicle is powered on, determining (103) whether a capacity calculation condition is satisfied;
   when determining that the capacity calculation condition is satisfied, calculating (104) a capacity; and
   calculating (105) the state of health of the battery according to the capacity variation and the capacity;
   wherein the capacity variation calculation condition comprises satisfying the following two conditions at the same time:

   capacity variation calculation condition A: a parking time is greater than or equal to S1;
   the S1 being a preset parking time threshold of the capacity variation calculation condition; and
   capacity variation calculation condition B: $SOC1 \leq SOC\_judge1$;
   the SOC1 being an SOC value of an OCV-SOC curve of the battery corresponding to a current voltage of a minimum unit voltage; and
   the SOC_judge1 being a preset state of charge threshold of the capacity variation calculation condition;
   wherein the step of calculating (204) the capacity variation comprises:

   calculating:

$$\Delta\mathrm{Cap} = \int_{\mathrm{T1}}^{\mathrm{RTC}} - \, Idt$$

$$\Delta\mathrm{DchaCap} = \int_{\mathrm{T1}}^{\mathrm{RTC}} I_{\mathrm{d}}dt$$

   wherein,
   T1 is a time point when determining that the capacity variation calculation condition is satisfied;
   RTC is a time to calculate $\Delta$Cap or $\Delta$DchaCap, which is capable of being acquired by internal timing of a BMS or acquired externally;
   $I$ is a current of the battery;

$I_d$ is a current in a discharge direction of the battery;

$\Delta$Cap is a capacity variation accumulated from a start time of T1; and

$\Delta$DchaCap is a capacity variation in the discharge direction accumulated from the start time of T1;

wherein the capacity calculation condition comprises satisfying the following four conditions:

capacity calculation condition A: a parking time is greater than or equal to S2;

the parking time being a time interval between last power-off and the present power-on; and

S2 being a preset time threshold of the capacity calculation condition;

capacity calculation condition B: SOC2≤SOC_judge2;

the SOC2 being an SOC value of the battery corresponding to a maximum unit voltage in an OCV-SOC curve; and

the SOC_judge2 being a preset SOC threshold of the capacity calculation condition;

capacity calculation condition C: CT-T1≤T_Judge;

wherein

the CT is the time point when determining whether the capacity calculation condition is satisfied;

T1 is the time point when determining that the capacity variation calculation condition is satisfied; and

T_Judge is a preset time difference threshold; and

capacity calculation condition D: $\Delta$DchaCap≤$\Delta$DchaCap_Judge;

wherein

the $\Delta$DchaCap is the capacity variation in the discharge direction accumulated from the start time of T1; and

the $\Delta$DchaCap_Judge is a preset upper limit of a capacity variation threshold;

wherein the step of calculating (206) the capacity comprises:

$$\mathrm{Cap\_cal} = \frac{\Delta Cap}{SOC2 - SOC1}$$

wherein

the Cap_cal is an actual capacity of the battery; and

the $\Delta$Cap is the capacity variation accumulated from the start time of T1,

wherein the step of calculating (207) the state of health of the battery according to the capacity variation and the capacity comprises:

calculating:

$$\mathrm{SOH\_C} = \frac{Cap\_cal}{Cap\_rate} \times 100\%$$

wherein

the SOH_C is the state of health of the battery; and

the Cap_rate is a nominal capacity of the battery delivered from a factory.

2. The method for acquiring the state of health of the battery according to claim 1, wherein before the step of determining (101) whether the capacity variation calculation condition is satisfied, the method further comprises:

when the vehicle is powered on, determining (201) whether an ongoing capacity variation calculation process exists at present;

if the ongoing capacity variation calculation process exists, performing (205) the step of determining whether the capacity calculation condition is satisfied; and

if no ongoing capacity variation calculation process exists, performing (203) the step of determining whether the capacity variation calculation condition is satisfied.

3. The method for acquiring the state of health of the battery according to claim 1, wherein before the step of determining (101) whether the capacity variation calculation condition is satisfied, the method further comprises:

when the vehicle is powered on, determining (201) whether an ongoing capacity variation calculation process exists at present;

if determining that the ongoing capacity variation calculation process exists, determining (202) whether the ongoing capacity variation calculation process is overdue;

if determining that no ongoing capacity variation calculation process exists, performing (203) the step of determining whether the capacity variation calculation condition is satisfied;

if determining the ongoing capacity variation calculation process is overdue, performing (203) the step of determining whether the capacity variation calculation condition is satisfied; and

if determining the ongoing capacity variation calculation process is not overdue, performing (205) the step of determining whether the capacity calculation condition is satisfied.

4. A device for acquiring a state of health of a battery, wherein the device comprises:

a capacity variation calculation condition determining module (301) configured for, when a vehicle is powered on, determining whether a capacity variation calculation condition is satisfied;
a capacity variation calculation module (302) configured for calculating a capacity variation;
a capacity calculation condition determining module (303) configured for, when the vehicle is powered on, determining whether a capacity calculation condition is satisfied;
a capacity calculation module (304) configured for calculating a capacity; and
a calculation module for state of health (305) configured for calculating the state of health of the battery according to the capacity variation and the capacity;
wherein the capacity variation calculation condition comprises satisfying the following two conditions at the same time:

capacity variation calculation condition A: a parking time is greater than or equal to S1;
the S1 being a preset parking time threshold of the capacity variation calculation condition; and
capacity variation calculation condition B: SOC1≤SOC_judge1;
the SOC1 being an SOC value of an OCV-SOC curve of the battery corresponding to a current voltage of a minimum unit voltage; and
the SOC_judge1 being a preset state of charge threshold of the capacity variation calculation condition;
wherein the capacity variation calculation module (302) configured for:

calculating:

$$\Delta \mathrm{Cap} = \int_{T1}^{RTC} - I dt$$

$$\Delta \mathrm{DchaCap} = \int_{T1}^{RTC} I_{d} dt$$

wherein
T1 is a time point when determining that the capacity variation calculation condition is satisfied;
RTC is a time to calculate $\Delta$Cap or $\Delta$DchaCap, which is capable of being acquired by internal timing of a BMS or acquired externally;
$I$ is a current of the battery;
$I_{d}$ is a current in a discharge direction of the battery;
$\Delta$Cap is a capacity variation accumulated from a start time of T1; and
$\Delta$DchaCap is a capacity variation in the discharge direction accumulated from the start time of T1;
wherein the capacity calculation condition comprises satisfying the following four conditions:

capacity calculation condition A: a parking time is greater than or equal to S2;
the parking time being a time interval between last power-off and the present power-on; and
S2 being a preset time threshold of the capacity calculation condition;
capacity calculation condition B: SOC2≤SOC_judge2;
the SOC2 being an SOC value of the battery corresponding to a maximum unit voltage in an OCV-SOC curve; and
the SOC_judge2 being a preset SOC threshold of the capacity calculation condition;
capacity calculation condition C: CT-T1≤T_Judge;
wherein

the CT is the time point when determining whether the capacity calculation condition is satisfied;

T1 is the time point when determining that the capacity variation calculation condition is satisfied; and

T_Judge is a preset time difference threshold; and

capacity calculation condition D: $\Delta DchaCap \leq \Delta DchaCap\_Judge$;

wherein

the $\Delta DchaCap$ is the capacity variation in the discharge direction accumulated from the start time of T1; and

the $\Delta DchaCap\_Judge$ is a preset upper limit of a capacity variation threshold;

wherein the capacity calculation module (304) is configured for:

$$Cap\_cal = \frac{\Delta Cap}{SOC2 - SOC1}$$

wherein

the Cap_cal is an actual capacity of the battery; and

the $\Delta Cap$ is the capacity variation accumulated from the start time of T1,

wherein the calculation module for state of health (305) is configured for:

calculating:

$$SOH\_C = \frac{Cap\_cal}{Cap\_rate} \times 100\%$$

wherein

the SOH_C is the state of health of the battery; and

the Cap_rate is a nominal capacity of the battery delivered from a factory.

5. A vehicle comprising the device for acquiring the state of health of the battery according to claim 4.

6. A computer program product comprising instructions to cause the device of claim 4 to execute the method for acquiring the state of health of the battery according to any one of claims 1 to 3.

7. A computer-readable storage medium comprising the computer program product according to claim 6.


**Patentansprüche**

1. Verfahren zum Erfassen eines Gesundheitszustands einer Batterie, wobei das Verfahren durch die Vorrichtung nach Anspruch 4 ausgeführt wird, und wobei das Verfahren umfasst:

wenn ein Fahrzeug eingeschaltet wird, Bestimmen (101), ob eine Kapazitätsänderungsberechnungsbedingung erfüllt ist;

wenn bestimmt wird, dass die Kapazitätsänderungsberechnungsbedingung erfüllt ist, Berechnen (102) einer Kapazitätsänderung;

wenn das Fahrzeug eingeschaltet wird, Bestimmen (103), ob eine Kapazitätsberechnungsbedingung erfüllt ist;

wenn bestimmt wird, dass die Kapazitätsberechnungsbedingung erfüllt ist, Berechnen (104) einer Kapazität; und

Berechnen (105) des Gesundheitszustands der Batterie gemäß der Kapazitätsänderung und der Kapazität;

wobei die Kapazitätsänderungsberechnungsbedingung das gleichzeitige Erfüllen der folgenden zwei Bedingungen umfasst:

Kapazitätsänderungsberechnungsbedingung A: eine Parkzeit ist länger als oder gleich S1;

wobei S1 eine voreingestellte Parkzeitschwelle der Kapazitätsänderungsberechnungsbedingung ist; und

Kapazitätsänderungsberechnungsbedingung B: SOC1 $\leq$ SOC_judge1;

wobei SOC1 ein SOC-Wert einer OCV-SOC-Kurve der Batterie ist, der einer momentanen Spannung einer Minimum-Einheitsspannung entspricht; und

wobei SOC_judge1 eine voreingestellte Ladungszustandsschwelle der Kapazitätsänderungsberechnungsbedingung ist;

wobei der Schritt des Berechnens (204) der Kapazitätsänderung umfasst:

Berechnen von:

$$\Delta\text{Cap} = \int_{T1}^{RTC} - I\,dt$$

$$\Delta\text{DchaCap} = \int_{T1}^{RTC} I_d\,dt$$

wobei

T1 ein Zeitpunkt ist, an dem bestimmt wird, dass die Kapazitätsänderungsberechnungsbedingung erfüllt ist;

RTC eine Zeit zum Berechnen von $\Delta$Cap oder $\Delta$DchaCap ist, die durch interne Zeitmessung eines BMS erfasst werden kann oder extern erfasst werden kann;

$I$ ein Strom der Batterie ist;

$I_d$ ein Strom in einer Entladungsrichtung der Batterie ist;

$\Delta$Cap eine Kapazitätsänderung ist, die ab einer Startzeit T1 akkumuliert wurde; und

$\Delta$DchaCap eine Kapazitätsänderung in der Entladungsrichtung ist, die ab der Startzeit T1 akkumuliert wurde;

wobei die Kapazitätsberechnungsbedingung das Erfüllen der folgenden vier Bedingungen umfasst:

Kapazitätsberechnungsbedingung A: eine Parkzeit ist länger als oder gleich S2;

wobei die Parkzeit ein Zeitintervall zwischen dem letzten Ausschalten und dem momentanen Einschalten ist; und

wobei S2 eine voreingestellte Zeitschwelle der Kapazitätsberechnungsbedingung ist;

Kapazitätsberechnungsbedingung B: SOC2$\leq$ SOC_judge2;

wobei SOC2 ein SOC-Wert der Batterie ist, der einer Maximum-Einheitsspannung in einer OCV-SOC-Kurve entspricht; und

wobei SOC_judge2 eine voreingestellte SOC-Schwelle der Kapazitätsberechnungsbedingung ist;

Kapazitätsberechnungsbedingung C: CT-T1$\leq$T_Judge;

wobei

CT der Zeitpunkt ist, an dem bestimmt wird, ob die Kapazitätsberechnungsbedingung erfüllt ist;

T1 der Zeitpunkt ist, an dem bestimmt wird, dass die Kapazitätsänderungsberechnungsbedingung erfüllt ist; und

T_Judge eine voreingestellte Zeitdifferenzschwelle ist; und

Kapazitätsberechnungsbedingung D: $\Delta$DchaCap $\leq\Delta$DchaCap_Judge;

wobei

$\Delta$DchaCap die Kapazitätsänderung in der Entladungsrichtung ist, die ab der Startzeit T1 akkumuliert wurde; und

$\Delta$DchaCap_Judge eine voreingestellte Obergrenze einer Kapazitätsänderungsschwelle ist;

wobei der Schritt des Berechnens (206) der Kapazität umfasst:

$$\text{Cap\_cal} = \frac{\Delta Cap}{SOC2 - SOC1}$$

wobei

Cap_cal eine tatsächliche Kapazität der Batterie ist; und

$\Delta$Cap die Kapazitätsänderung ist, die ab der Startzeit T1 akkumuliert wurde;

wobei der Schritt des Berechnens (207) des Gesundheitszustands der Batterie gemäß der Kapazitätsänderung und der Kapazität umfasst:

Berechnen von:

$$SOH\_C = \frac{\overline{Cap\_cal}}{Cap\_rate} \times 100\%$$

wobei

SOH_C der Gesundheitszustand der Batterie ist; und

Cap_rate eine Nennkapazität der von einer Fertigungsstätte gelieferten Batterie ist.

2. Verfahren zum Erfassen des Gesundheitszustands der Batterie nach Anspruch 1, wobei vor dem Schritt des Bestimmens (101), ob die Kapazitätsänderungsberechnungsbedingung erfüllt ist, das Verfahren des Weiteren umfasst:

wenn das Fahrzeug eingeschaltet wird, Bestimmen (201), ob gerade ein Kapazitätsänderungsberechnungsprozess abläuft;

wenn gerade ein Kapazitätsänderungsberechnungsprozess abläuft, Durchführen (205) des Schrittes des Bestimmens, ob die Kapazitätsberechnungsbedingung erfüllt ist; und

wenn gerade kein Kapazitätsänderungsberechnungsprozess abläuft, Durchführen (203) des Schrittes des Bestimmens, ob die Kapazitätsänderungsberechnungsbedingung erfüllt ist.

3. Verfahren zum Erfassen des Gesundheitszustands der Batterie nach Anspruch 1, wobei vor dem Schritt des Bestimmens (101), ob die Kapazitätsänderungsberechnungsbedingung erfüllt ist, das Verfahren des Weiteren umfasst:

wenn das Fahrzeug eingeschaltet wird, Bestimmen (201), ob gerade ein Kapazitätsänderungsberechnungsprozess abläuft;

wenn bestimmt wird, dass gerade ein Kapazitätsänderungsberechnungsprozess abläuft, Bestimmen (202), ob der gerade ablaufende Kapazitätsänderungsberechnungsprozess überfällig ist;

wenn bestimmt wird, dass gerade kein Kapazitätsänderungsberechnungsprozess abläuft, Durchführen (203) des Schrittes des Bestimmens, ob die Kapazitätsänderungsberechnungsbedingung erfüllt ist;

wenn bestimmt wird, dass der gerade ablaufende Kapazitätsänderungsberechnungsprozess überfällig ist, Durchführen (203) des Schrittes des Bestimmens, ob die Kapazitätsänderungsberechnungsbedingung erfüllt ist; und

wenn bestimmt wird, dass der gerade ablaufende Kapazitätsänderungsberechnungsprozess nicht überfällig ist, Durchführen (205) des Schrittes des Bestimmens, ob die Kapazitätsberechnungsbedingung erfüllt ist.

4. Vorrichtung zum Erfassen eines Gesundheitszustands einer Batterie, wobei die Vorrichtung umfasst:

ein Kapazitätsänderungsberechnungsbedingungs-Bestimmungsmodul (301), das dazu eingerichtet ist, wenn das Fahrzeug eingeschaltet ist, zu bestimmen, ob eine Kapazitätsänderungsberechnungsbedingung erfüllt ist;

ein Kapazitätsänderungsberechnungsmodul (302), das dazu eingerichtet ist, eine Kapazitätsänderung zu berechnen;

ein Kapazitätsberechnungsbedingung-Bestimmungsmodul (303), das dazu eingerichtet ist, wenn das Fahrzeug eingeschaltet ist, zu bestimmen, ob eine Kapazitätsberechnungsbedingung erfüllt ist;

ein Kapazitätsberechnungsmodul (304), das dazu eingerichtet ist, eine Kapazität zu berechnen; und

ein Berechnungsmodul für den Gesundheitszustand (305), das dazu eingerichtet ist, den Gesundheitszustand der Batterie gemäß der Kapazitätsänderung und der Kapazität zu berechnen;

wobei die Kapazitätsänderungsberechnungsbedingung das gleichzeitige Erfüllen der folgenden zwei Bedingungen umfasst:

Kapazitätsänderungsberechnungsbedingung A: eine Parkzeit ist länger als oder gleich S1;

wobei S1 eine voreingestellte Parkzeitschwelle der Kapazitätsänderungsberechnungsbedingung ist; und

Kapazitätsänderungsberechnungsbedingung B: $SOC1 \leq SOC\_judge1$;

wobei SOC1 ein SOC-Wert einer OCV-SOC-Kurve der Batterie ist, der einer momentanen Spannung einer Minimum-Einheitsspannung entspricht; und

wobei SOC_judge1 eine voreingestellte Ladungszustandsschwelle der Kapazitätsänderungsberechnungsbedingung ist;

wobei das Kapazitätsänderungsberechnungsmodul (302) eingerichtet ist zum:

Berechnen von:

$$\Delta \text{Cap} = \int_{T1}^{RTC} - I dt$$

$$\Delta \text{DchaCap} = \int_{T1}^{RTC} I_d dt$$

wobei

T1 ein Zeitpunkt ist, an dem bestimmt wird, dass die Kapazitätsänderungsberechnungsbedingung erfüllt ist;

RTC eine Zeit zum Berechnen von $\Delta$Cap oder $\Delta$DchaCap ist, die durch interne Zeitmessung eines BMS erfasst werden kann oder extern erfasst werden kann;

$I$ ein Strom der Batterie ist;

$I_d$ ein Strom in einer Entladungsrichtung der Batterie ist;

$\Delta$Cap eine Kapazitätsänderung ist, die ab einer Startzeit T1 akkumuliert wurde; und

$\Delta$DchaCap eine Kapazitätsänderung in der Entladungsrichtung ist, die ab der Startzeit T1 akkumuliert wurde;

wobei die Kapazitätsberechnungsbedingung das Erfüllen der folgenden vier Bedingungen umfasst:

Kapazitätsberechnungsbedingung A: eine Parkzeit ist länger als oder gleich S2;

wobei die Parkzeit ein Zeitintervall zwischen dem letzten Ausschalten und dem momentanen Einschalten ist; und

wobei S2 eine voreingestellte Zeitschwelle der Kapazitätsberechnungsbedingung ist;

Kapazitätsberechnungsbedingung B: $SOC2 \leq SOC\_judge2$;

wobei SOC2 ein SOC-Wert der Batterie ist, der einer Maximum-Einheitsspannung in einer OCV-SOC-Kurve entspricht; und

wobei SOC_judge2 eine voreingestellte SOC-Schwelle der Kapazitätsberechnungsbedingung ist;

Kapazitätsberechnungsbedingung C: $CT-T1 \leq T\_Judge$;

wobei

CT der Zeitpunkt ist, an dem bestimmt wird, ob die Kapazitätsberechnungsbedingung erfüllt ist;

T1 der Zeitpunkt ist, an dem bestimmt wird, dass die Kapazitätsänderungsberechnungsbedingung erfüllt ist; und

T_Judge eine voreingestellte Zeitdifferenzschwelle ist; und

Kapazitätsberechnungsbedingung D: $\Delta$DchaCap $\leq \Delta$DchaCap_Judge;

wobei

$\Delta$DchaCap die Kapazitätsänderung in der Entladungsrichtung ist, die ab der Startzeit T1 akkumuliert wurde; und

$\Delta$DchaCap_Judge eine voreingestellte Obergrenze einer Kapazitätsänderungsschwelle ist;

wobei das Kapazitätsberechnungsmodul (304) eingerichtet ist zum:

$$\text{Cap\_cal} = \frac{\Delta \text{Cap}}{SOC2 - SOC1}$$

wobei

Cap_cal eine tatsächliche Kapazität der Batterie ist; und

$\Delta$Cap die Kapazitätsänderung ist, die ab der Startzeit T1 akkumuliert wurde;

wobei das Berechnungsmodul für den Gesundheitszustand (305) eingerichtet ist zum:

Berechnen von:

$$\text{SOH\_C} = \frac{\text{Cap\_cal}}{\text{Cap\_rate}} \times 100\%$$

wobei

SOH_C der Gesundheitszustand der Batterie ist; und

Cap_rate eine Nennkapazität der von einer Fertigungsstätte gelieferten Batterie ist.

5. Fahrzeug, umfassend die Vorrichtung zum Erfassen des Gesundheitszustands der Batterie nach Anspruch 4.

6. Computerprogrammprodukt, umfassend Instruktionen, um die Vorrichtung nach Anspruch 4 zu veranlassen, das Verfahren zum Erfassen des Gesundheitszustands der Batterie nach einem der Ansprüche 1 bis 3 auszuführen.

7. Computerlesbares Speichermedium, umfassend das Computerprogrammprodukt nach Anspruch 6.


**Revendications**

1. Procédé pour acquérir un état de santé d'une batterie, dans lequel le procédé est mis en œuvre par le dispositif selon la revendication 4, et dans lequel le procédé comprend de :

lorsqu'un véhicule est mis sous tension, déterminer (101) si une condition de calcul de variation de capacité est satisfaite ;
lorsqu'il est déterminé que la condition de calcul de variation de capacité est satisfaite, calculer (102) une variation de capacité ;
lorsque le véhicule est mis sous tension, déterminer (103) si une condition de calcul de capacité est satisfaite ;
lorsqu'il est déterminé que la condition de calcul de capacité est satisfaite, calculer (104) une capacité ; et
calculer (105) l'état de santé de la batterie en fonction de la variation de capacité et de la capacité ;
dans lequel la condition de calcul de variation de capacité comprend de satisfaire aux deux conditions suivantes en même temps :

condition de calcul de variation de capacité A : un temps de stationnement est supérieur ou égal à S1 ;
S1 étant un seuil de temps de stationnement prédéfini de la condition de calcul de variation de capacité ; et
condition de calcul de variation de capacité B : SOC1 ≤ SOC_judge 1 ;
SOC1 étant une valeur de SOC d'une courbe OCV-SOC de la batterie correspondant à une tension actuelle d'une tension unitaire minimale ; et
SOC_judge1 étant un seuil d'état de charge prédéfini de la condition de calcul de variation de capacité ;
dans lequel l'étape consistant à calculer (204) la variation de capacité comprend de :

calculer :

$$\Delta \text{Cap} = \int_{T1}^{RTC} - I\,dt$$

$$\Delta \text{DchaCap} = \int_{T1}^{RTC} I_d\,dt$$

où
T1 est un instant où il est déterminé que la condition de calcul de variation de capacité est satisfaite ;
RTC est un temps pour calculer $\Delta$Cap ou $\Delta$DchaCap, qui peut être acquis par synchronisation interne d'un BMS ou être acquis en externe ;
$I$ est un courant de la batterie ;
$I_d$ est un courant dans un sens de décharge de la batterie ;
$\Delta$Cap est une variation de capacité accumulée à partir d'un instant de début de T1 ; et
$\Delta$DchaCap est une variation de capacité dans le sens de décharge accumulée à partir de l'instant de début de T1 ;
dans lequel la condition de calcul de capacité comprend de satisfaire aux quatre conditions suivantes :

condition de calcul de capacité A : un temps de stationnement est supérieur ou égal à S2 ;
le temps de stationnement étant un intervalle de temps entre la dernière mise hors tension et la mise sous tension actuelle ; et
S2 étant un seuil de temps prédéfini de la condition de calcul de capacité ;
condition de calcul de capacité B : SOC2 ≤ SOC_judge2 ;
SOC2 étant une valeur de SOC de la batterie correspondant à une tension unitaire maximale sur une courbe OCV-SOC ; et

SOC_judge2 étant un seuil de SOC prédéfini de la condition de calcul de capacité ;

condition de calcul de capacité C : CT-T1 $\leq$ T_Judge ;

où

CT est l'instant où il est déterminé si la condition de calcul de capacité est satisfaite ;

T1 est l'instant où il est déterminé que la condition de calcul de variation de capacité est satisfaite ; et

T_Judge est un seuil de différence de temps prédéfini ; et

condition de calcul de capacité D : $\Delta$DchaCap $\leq$ $\Delta$DchaCap_Judge ;

où

$\Delta$DchaCap est la variation de capacité dans le sens de décharge accumulée à partir de l'instant de début de T1 ; et

$\Delta$DchaCap_Judge est une limite supérieure prédéfinie d'un seuil de variation de capacité,

dans lequel l'étape consistant à calculer (206) la capacité comprend :

$$Cap\_cal = \frac{\Delta Cap}{SOC2 - SOC1}$$

où

Cap_cal est une capacité réelle de la batterie ; et

$\Delta$Cap est la variation de capacité accumulée à partir de l'instant de début de T1,

dans lequel l'étape de calcul (207) de l'état de santé de la batterie en fonction de la variation de capacité et de la capacité comprend de :

calculer :

$$SOH\_C = \frac{Cap\_cal}{Cap\_rate} \times 100\%$$

où

SOH_C est l'état de santé de la batterie ; et

Cap_rate est une capacité nominale de la batterie fournie à partir d'une usine.

2. Procédé pour acquérir l'état de santé de la batterie selon la revendication 1, dans lequel,
avant l'étape consistant à déterminer (101) si la condition de calcul de variation de capacité est satisfaite, le procédé comprend en outre de :

lorsque le véhicule est mis sous tension, déterminer (201) si un processus de calcul de variation de capacité est actuellement exécuté ;

si le processus de calcul de variation de capacité est actuellement exécuté, réaliser (205) l'étape consistant à déterminer si la condition de calcul de capacité est satisfaite ; et

si aucun processus de calcul de variation de capacité n'est actuellement exécuté, réaliser (203) l'étape consistant à déterminer si la condition de calcul de variation de capacité est satisfaite.

3. Procédé pour acquérir l'état de santé de la batterie selon la revendication 1, dans lequel,
avant l'étape consistant à déterminer (101) si la condition de calcul de variation de capacité est satisfaite, le procédé comprend en outre de :

lorsque le véhicule est mis sous tension, déterminer (201) si un processus de calcul de variation de capacité est actuellement exécuté ;

s'il est déterminé que le processus de calcul de variation de capacité est actuellement exécuté, déterminer (202) si le processus de calcul de variation de capacité actuellement exécuté est en retard ;

s'il est déterminé qu'aucun processus de calcul de variation de capacité n'est actuellement exécuté, réaliser (203) l'étape consistant à déterminer si la condition de calcul de variation de capacité est satisfaite ;

s'il est déterminé que le processus de calcul de variation de capacité actuellement exécuté est en retard, réaliser (203) l'étape consistant à déterminer si la condition de calcul de variation de capacité est satisfaite ; et

s'il est déterminé que le processus de calcul de variation de capacité actuellement exécuté n'est pas en retard, réaliser (205) l'étape consistant à déterminer si la condition de calcul de capacité est satisfaite.

4. Dispositif pour acquérir un état de santé d'une batterie, dans lequel le dispositif comprend :

un module de détermination de condition de calcul de variation de capacité (301) configuré pour, lorsqu'un véhicule est mis sous tension, déterminer si une condition de calcul de variation de capacité est satisfaite ;
un module de calcul de variation de capacité (302) configuré pour calculer une variation de capacité ;
un module de détermination de condition de calcul de capacité (303) configuré pour, lorsque le véhicule est mis sous tension, déterminer si une condition de calcul de capacité est satisfaite ;
un module de calcul de capacité (304) configuré pour calculer une capacité ; et
un module de calcul d'état de santé (305) configuré pour calculer l'état de santé de la batterie en fonction de la variation de capacité et de la capacité ;
dans lequel la condition de calcul de variation de capacité comprend de satisfaire aux deux conditions suivantes en même temps :

condition de calcul de variation de capacité A : un temps de stationnement est supérieur ou égal à S1 ;
S1 étant un seuil de temps de stationnement prédéfini de la condition de calcul de variation de capacité ; et
condition de calcul de variation de capacité B : SOC1 ≤ SOC_judge 1 ;
SOC1 étant une valeur de SOC d'une courbe OCV-SOC de la batterie correspondant à une tension actuelle d'une tension unitaire minimale ; et
SOC_judge1 étant un seuil d'état de charge prédéfini de la condition de calcul de variation de capacité ;
dans lequel le module de calcul de variation de capacité (302) est configuré pour :
calculer :

$$\Delta\text{Cap} = \int_{T1}^{RTC} - I\,dt$$

$$\Delta\text{DchaCap} = \int_{T1}^{RTC} I_d\,dt$$

où
T1 est un instant où il est déterminé que la condition de calcul de variation de capacité est satisfaite ;
RTC est un temps pour calculer ΔCap ou ΔDchaCap, qui peut être acquis par synchronisation interne d'un BMS ou être acquis en externe ;
$I$ est un courant de la batterie ;
$I_d$ est un courant dans un sens de décharge de la batterie ;
ΔCap est une variation de capacité accumulée à partir d'un instant de début de T1 ; et
ΔDchaCap est une variation de capacité dans le sens de décharge accumulée à partir de l'instant de début de T1 ;
dans lequel la condition de calcul de capacité comprend de satisfaire aux quatre conditions suivantes :

condition de calcul de capacité A : un temps de stationnement est supérieur ou égal à S2 ;
le temps de stationnement étant un intervalle de temps entre la dernière mise hors tension et la mise sous tension actuelle ; et
S2 étant un seuil de temps prédéfini de la condition de calcul de capacité ;
condition de calcul de capacité B : SOC2 ≤ SOC_judge2 ;
SOC2 étant une valeur de SOC de la batterie correspondant à une tension unitaire maximale sur une courbe OCV-SOC ; et
SOC_judge2 étant un seuil de SOC prédéfini de la condition de calcul de capacité ;
condition de calcul de capacité C : CT-T1 ≤ T_Judge ;
où
CT est l'instant où il est déterminé si la condition de calcul de capacité est satisfaite ;
T1 est l'instant où il est déterminé que la condition de calcul de variation de capacité est satisfaite ; et
T_Judge est un seuil de différence de temps prédéfini ; et
condition de calcul de capacité D : ΔDchaCap ≤ ΔDchaCap_Judge ;
où
ΔDchaCap est la variation de capacité dans le sens de décharge accumulée à partir de l'instant de début de T1 ; et
ΔDchaCap_Judge est une limite supérieure prédéfinie d'un seuil de variation de capacité,
dans lequel le module de calcul de capacité (304) est configuré pour :

$$Cap\_cal = \frac{\Delta Cap}{SOC2 - SOC1}$$

où

Cap_cal est une capacité réelle de la batterie ; et

ΔCap est la variation de capacité accumulée à partir de l'instant de début de T1,

dans lequel le module de calcul de l'état de santé (305) est configuré pour :

calculer .

$$SOH\_C = \frac{Cap\_cal}{Cap\_rate} \times 100\%$$

où

SOH_C est l'état de santé de la batterie ; et

Cap_rate est une capacité nominale de la batterie fournie à partir d'une usine.

5. Véhicule comprenant le dispositif pour acquérir l'état de santé de la batterie selon la revendication 4.

6. Produit de programme informatique comprenant des instructions pour amener le dispositif de la revendication 4 à exécuter le procédé d'acquisition de l'état de santé de la batterie selon l'une quelconque des revendications 1 à 3.

7. Support de stockage lisible par ordinateur comprenant le produit de programme informatique selon la revendication 6.

when a vehicle is powered on, determining whether a capacity variation calculation condition is satisfied ⟋ 101

↓

when determining that the capacity variation calculation condition is satisfied, calculating a capacity variation ⟋ 102

↓

when the vehicle is powered on, determining whether a capacity calculation condition is satisfied ⟋ 103

↓

when determining that the capacity calculation condition is satisfied, calculating a capacity ⟋ 104

↓

calculating the state of health of the battery according to the capacity variation and the capacity ⟋ 105

FIG. 1

FIG. 2

```
┌─────────────────────────────────────────┐
│      capacity variation calculation       │
│   condition determining module 301        │
└─────────────────────────────────────────┘
                    │
┌─────────────────────────────────────────┐
│   capacity variation calculation module    │
│                  302                       │
└─────────────────────────────────────────┘
                    │
┌─────────────────────────────────────────┐
│      capacity calculation condition        │
│        determining module 303              │
└─────────────────────────────────────────┘
                    │
┌─────────────────────────────────────────┐
│      capacity calculation module 304       │
└─────────────────────────────────────────┘
                    │
┌─────────────────────────────────────────┐
│   calculation module for state of health   │
│                  305                       │
└─────────────────────────────────────────┘
```

FIG. 3

**EP 3 951 408 B1**

## REFERENCES CITED IN THE DESCRIPTION

**Patent documents cited in the description**

- US 20150346285 A1
- US 20150120225 A1
- US 20040257045 A1
- CN 108061863 A